# EUROPEAN PATENT APPLICATION

(11) **EP 2 613 611 A1**
(43) Date of publication of application: **10.07.2013**
(21) Application number: 11821549.0
(22) Date of filing: 12.08.2011
(51) Int. Cl.: H05B 33/28, G09F 9/30, H01L 27/32, H01L 51/50, H05B 33/02, H05B 33/22, F21Y 105/00

(54) **ELECTROLUMINESCENT ELEMENT, DISPLAY DEVICE AND LIGHTING DEVICE**

(30) Priority: 01.09.2010 JP 2010195378
(71) Applicant: Showa Denko K.K., Tokyo 105-8518 (JP)
(72) Inventor: TAJIMA, Masaru, Tokyo 105-8518 (JP); YAMAZAKI, Yusuke, Tokyo 105-8518 (JP); TAKAHASHI, Yoshiaki, Tokyo 105-8518 (JP)
(74) Representative: Strehl Schübel-Hopf & Partner
(86) International application number: PCT/JP2011/068437
(87) International publication number: WO 2012/029531

(57) **Abstract**

An electroluminescent element (10) is provided with: a lamination section in which a first conductive layer (12), a dielectric layer (13), a second conductive layer (14), a light-emitting layer (15) and a third conductive layer (16) are laminated in order; and contact holes (17) for at least penetrating through the dielectric layer (13) and electrically connecting the first conductive layer (12) and the second conductive layer (14). When viewed from the light-emitting surface side, the electroluminescent element (10) (i) has at least one continuous light-emitting region, and (ii) the number of contact holes (17) is 10² or more per one light-emitting region and such that the ratio of the area of the contact holes (17) to the area of the light-emitting region is 0.1 or less. Thus, it is possible to provide an electroluminescent element, etc., that is easily manufactured and has high light emission uniformity.

## Description

### Technical Field

The present invention relates to an electroluminescent element or the like used for, for example, a display device or a lighting device.

### Background Art

In recent years, devices utilizing the electroluminescence phenomenon have increased in importance. As such a device, an electroluminescent element in which light-emitting materials are formed to be a light-emitting layer, and a pair of electrodes including an anode and a cathode is attached to the light-emitting layer, and light is emitted by applying a voltage thereto, becomes a focus of attention. In this kind of electroluminescent element, holes and electrons are injected from the anode and the cathode, respectively, by applying a voltage between the anode and the cathode, and an energy generated by coupling the injected electrons and holes in the light-emitting layer is used to perform light emission. In other words, the electroluminescent element is a device utilizing a phenomenon in which the light-emitting material of the light-emitting layer is excited by the energy produced by the coupling, and light is emitted when an excited state returns to a ground state again.

In the case where the electroluminescent element is used as a display device, since the light-emitting material is capable of self-emitting, the device has characteristics that a response speed as the display device is fast and a view angle is wide. Further, due to its structural feature of the electroluminescent element, there is an advantage that the thickness of the display device may be reduced with ease. Moreover, in the case of an organic electroluminescent element using, for example, an organic substance as the light-emitting material, characteristics are obtained such that light with high color purity is readily obtained depending upon selection of the organic substance, and thereby a wide color gamut is available.
Further, since the electroluminescent element is capable of emitting white light, and is an area light source, usage of the electroluminescent element to be incorporated into a lighting device is suggested.

Conventionally, there is known, as an electroluminescent element, an organic layer including a light-emitting layer that is formed to be interposed between a cathode and an anode, in which the light-emitting layer in a region where the anode and the cathode overlap emits light by application of voltage between the electrodes.
Moreover, in Patent Document 1, an organic light-emitting element is disclosed, in which one of electrodes is electrically connected to a semiconductor layer, and thereby a light-emitting layer interposed between the semiconductor layer and the other one of electrodes emits light. In this organic light-emitting element, since emitted light is able to be extracted from the semiconductor layer to the outside, the electrodes can be formed by an opaque material, and therefore, a metal having high conductivity and stability is able to be used as a material of the electrodes.

### Citation List

### Patent Literature

Patent Document 1: International Publication WO00/67531 Pamphlet

### Disclosure of Invention

### Technical Problem

Here, in the electroluminescent element, in which one of the electrodes is electrically connected to the semiconductor layer and the light-emitting layer interposed between the semiconductor layer and the other electrode emits light, the semiconductor layer is required to be formed in contact with the electrode after the electrodes are patterned. Accordingly, in a case where the electrodes are formed in a fine pattern, it becomes difficult to form a smooth semiconductor layer between the electrodes, and therefore, light emission within a light-emitting surface tends to be non-uniform. In addition, for smoothing the semiconductor layer, a smoothing process is required separately, to thereby complicate the production process and lead to increase in production cost.
In light of the above problem, an object of the present invention is to provide an electroluminescent element that has a smooth light-emitting surface in a light-emitting portion, has high uniformity in light emission, and is easy to be produced.
Moreover, another object of the present invention is to provide a display device and a lighting device having high uniformity in light emission.

### Solution to Problem

An electroluminescent element according to the present invention includes: a lamination section in which a first conductive layer, a dielectric layer, a second conductive layer, a light-emitting layer and a third conductive layer are laminated in order; and contact holes that penetrate through at least the dielectric layer to electrically connect the first conductive layer and the second conductive layer, wherein, as viewed from a light-emitting surface side, (i) at least one continuous light-emitting region is provided, and (ii) a number of the contact holes is not less than 10² per the one light-emitting region and a ratio of an area of the contact holes to an area of the light-emitting region is not more than 0.1.
When both surfaces of the electroluminescent element are the light-emitting surfaces, it is preferable that the both surfaces satisfy the above-described (i) and (ii).

Here, one light-emitting region is, as viewed from the light-emitting surface side, a region in which a light-emitting portion is continuous without any gap, and also a region that includes the contact holes involved in the region.
Moreover, it is preferable that the ratio of the area of the contact holes to the area of the light-emitting region is 0.001 to 0.1, a diameter of a minimum circle enclosing a shape of each contact hole as viewed from the light-emitting surface side is 0.01 µm to 2 µm, and the contact holes are formed to further penetrate through the first conductive layer.

Further, it is preferable that the first conductive layer, the dielectric layer and the second conductive layer are transparent to a wavelength of light to be emitted, and a refractive index of the dielectric layer is 1.0 to 1.5.

Still further, it is preferable that the second conductive layer includes one of conductive metal oxide and conductive polymer, and at least one layer, which is selected from a hole transporting layer, a hole blocking layer and an electron transporting layer, is further provided between the second conductive layer and the third conductive layer.

Moreover, a display device according to the present invention includes the electroluminescent element described above.

Moreover, a lighting device according to the present invention includes the electroluminescent element described above.

### Advantageous Effects of Invention

According to the present invention, it is possible to provide an electroluminescent element that is easily manufactured and has high uniformity in light emission.

### Brief Description of Drawings

FIG. 1 is a partial cross-sectional view illustrating a specific example of a light-emitting region of an electroluminescent element to which the exemplary embodiment is applied;
FIGS. 2A to 2E are diagrams illustrating a manufacturing method of the electroluminescent element to which the exemplary embodiment is applied;
FIG. 3 is a diagram for illustrating a specific example of a display device using the electroluminescent element in the exemplary embodiment;
FIG. 4 is a diagram for illustrating a specific example of a lighting device including the electroluminescent element in the exemplary embodiment; and
FIGS. 5A and 5B are diagrams illustrating a minimum enclosing circle that represents a size of a contact hole in the exemplary embodiment.

### Description of Embodiments

### (Electroluminescent Element)

Hereinafter, an exemplary embodiment of the present invention will be described in detail with reference to the attached drawings.

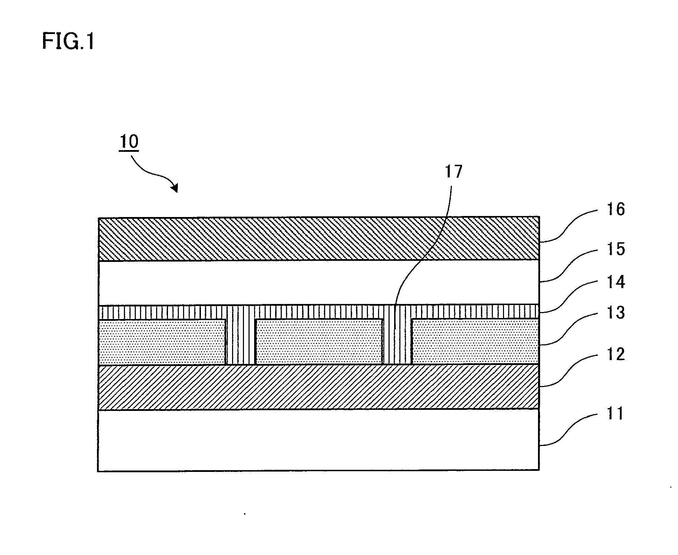

FIG. 1 is a partial cross-sectional view illustrating a specific example of a light-emitting region of an electroluminescent element to which the exemplary embodiment is applied.
The electroluminescent element 10 shown in FIG. 1 includes a lamination section with a configuration in which, on a substrate 11: a first conductive layer 12 for injecting holes; a dielectric layer 13 having insulation properties; a second conductive layer 14 that covers a top surface of the dielectric layer 13 and is electrically connected to the first conductive layer 12; a light-emitting layer 15 that emits light upon coupling the holes and electrons; and a third conductive layer 16 for injecting the electrons are laminated in order. In addition, in the dielectric layer 13, contact holes 17 are formed. Inside of the contact hole 17 is filled with a component of the second conductive layer 14. This connects the first conductive layer 12 and the second conductive layer 14 electrically via the contact holes 17. Consequently, by applying a voltage between the first conductive layer 12 and the third conductive layer 16, a voltage is applied between the second conductive layer 14 and the third conductive layer 16, to thereby cause the light-emitting layer 15 to emit light. In this case, a light-emitting surface of the electroluminescent element 10 is a surface on the substrate 11 side and/or a surface opposite thereto.

The substrate 11 serves as a support body for forming the first conductive layer 12, the dielectric layer 13, the second conductive layer 14, the light-emitting layer 15 and the third conductive layer 16. For the substrate 11, a material that satisfies mechanical strength required for the electroluminescent element 10 is used. Normally, a material that satisfies mechanical strength necessary for a support body like this is used for the substrate 11.

The material for the substrate 11, in the case where the light is to be taken out from the substrate 11 side of the electroluminescent element 10 (in the case where the surface of the substrate 11 side is the surface from which the light is taken out, namely, the light-emitting surface), is preferably to be transparent to the wavelength of the emitted light. Specific examples thereof include: glasses such as soda glass and non-alkali glass; transparent plastics such as acrylic resins, methacrylic resins, polycarbonate resins, polyester resins and nylon resins; and silicon.
In the case where it is unnecessary to take out the light from the substrate 11 side of the electroluminescent element 10, the material of the substrate 11 is not limited to the ones which are transparent, and may be opaque. The specific examples of the material of the substrate 11 include: in addition to the above-described materials, simple substances such as copper (Cu), silver (Ag), gold (Au), platinum (Pt), tungsten (W), titanium (Ti), tantalum (Ta) or niobium (Nb); alloys thereof; stainless steel or the like.
Although the thickness of the substrate 11 depends on the required mechanical strength, it is preferably 0.1 mm to 10 mm, and more preferably 0.25 mm to 2 mm.

A voltage is applied between the first conductive layer 12 and the third conductive layer 16, and holes are injected from the first conductive layer 12 to the light-emitting layer 15 via the second conductive layer 14. In other words, in the exemplary embodiment, the first conductive layer 12 is an anode layer. A material used for the first conductive layer 12 is not particularly limited as long as the material has electric conductivity; however, a surface resistance of the material in a temperature range of -5°C to 80°C is preferably 1000Ω or less, and more preferably, 100Ω or less. In addition, it is preferable that the electric resistance is not notably changed for an alkaline aqueous solution.

As the material satisfying such requirements, conductive metal oxides, metals or alloys can be used. Here, as the conductive metal oxides, indium tin oxide (ITO) and indium zinc oxide (IZO) are provided, for example. As the metals, provided are: stainless steel, copper (Cu); silver (Ag); gold (Au); platinum (Pt); tungsten (W); titanium (Ti); tantalum (Ta); niobium (Nb) and the like. Further, alloys including these metals can also be used. As the transparent materials used for forming a transparent electrode, specific examples include: conductive glasses (NESA or the like) composed of indium oxide, zinc oxide, tin oxide, indium tin oxide (ITO) and indium zinc oxide (IZO), which are complexes thereof, and the like; gold; platinum; silver and copper. Of these, ITO, IZO and tin oxide are preferred. In addition, a transparent conductive film composed of organic substances such as polyaniline or derivatives thereof, polythiophene or derivatives thereof and the like may be used.

The thickness of the first conductive layer 12 is, in the case where the light is to be taken out from the substrate 11 side of the electroluminescent element 10, preferably 2 nm to 300 nm for obtaining high optical transparency. Further, in the case where there is no need to take out the light from the substrate 11 side of the electroluminescent element 10, the first conductive layer 12 can be formed with a thickness of, for example, 2 nm to 2 mm.
Note that, for the substrate 11, a material same as that of the first conductive layer 12 can also be used. In this case, the substrate 11 may serve as the first conductive layer 12.

The dielectric layer 13 is laminated on the first conductive layer 12 and, in a region where the contact holes 17 are not provided, separates the first conductive layer 12 from the second conductive layer 14 to provide insulation therebetween. Thus, the dielectric layer 13 is preferably made of a material having high resistivity, and the resistivity thereof is preferably 10⁸ Ω·cm or more, and more preferably 10¹² Ω·cm or more. Specific examples of the material of the dielectric layer 13 include: metal nitrides such as silicon nitride, boron nitride and aluminum nitride; and metal oxides such as silicon oxide and aluminum oxide; and in addition, polymer compounds such as polyimide, polyvinylidene fluoride and parylene can be used.
Moreover, in the case where the light is to be taken out from the surface of the substrate 11 side, it is possible to increase the light to be taken out of the substrate 11 by refracting the light incident from the light-emitting layer 15 to change the traveling direction of the light. To do this, a refractive index of the dielectric layer 13 is preferably in a range of 1.0 to 1.5.

It is preferable that the thickness of the dielectric layer 13 does not exceed 1 µm for suppressing electrical resistance between the first conductive layer 12 and the second conductive layer 14. However, if it is too thin, dielectric strength becomes possibly insufficient. Accordingly, the dielectric layer 13 may be formed with a thickness of preferably 10 nm to 500 nm, and more preferably, 50 nm to 200 nm.
Moreover, the refractive index of the dielectric layer 13 is preferably in a range of 1.0 to 1.5 for taking out the light to the outside easier.

The second conductive layer 14 electrically connects the first conductive layer 12 inside the contact hole 17 to inject the holes received from the first conductive layer 12 into the light-emitting layer 15. It is preferable that the second conductive layer 14 includes conductive metal oxides or conductive polymers. Specifically, the second conductive layer 14 is preferably a transparent conductive film composed of ITO, IZO or tin oxide, which has optical transparency, and an organic substance. Moreover, in the exemplary embodiment, since the inside of the contact hole 17 is filled with a material to form the second conductive layer 14, it is preferable that the second conductive layer 14 is formed by coating for making it easy to forming a film on an inner surface of the contact hole 17. Accordingly, from this point of view, it is especially preferable that the second conductive layer 14 is a transparent conductive film composed of an organic substance. Note that the material of the second conductive layer 14 may be the same as that of the first conductive layer 12.

The thickness of the second conductive layer 14 is, in the case where the light is to be taken out from the substrate 11 side of the electroluminescent element 10, preferably 2 nm to 300 nm for obtaining high optical transparency.
Moreover, a layer for facilitating injection of the holes into the light-emitting layer 15 may be provided on a surface of the second conductive layer 14 that is in contact with the light-emitting layer 15. Specifically, it is possible to realize the layer by forming a layer of 1 nm to 200 nm composed of conductive polymers such as phthalocyanine derivatives, polythiophene derivatives and the like, Mo oxides, amorphous carbon, carbon fluoride, polyamine compound and the like, or a layer having an average thickness of 10 nm or less composed of metal oxides, metal fluorides, organic insulating materials and the like.

The light-emitting layer 15 includes a light-emitting material that emits light upon application of a voltage.
For the light-emitting material of the light-emitting layer15, any of organic materials and inorganic materials can be used. As the organic materials, any of low-molecular compounds and polymer compounds can be used. As light-emitting organic materials, phosphorescent organic compounds and metal complexes are preferred. Among the metal complexes, there exist ones that show phosphorescence, and such metal complexes are also preferably used. In the present invention, in particular, it is exceptionally desirable to use cyclometalated complexes in terms of improving light-emitting efficiency. As the cyclometalated complexes, complexes of Ir, Pd, Pt and the like including ligands such as 2-phenylpyridine derivatives, 7, 8-benzoquinoline derivatives, 2-(2-thienyl)pyridine derivatives, 2-(1-naphthyl)pyridine derivatives, 2-phenylquinoline derivatives are provided, and iridium (Ir) complexes are especially preferred. The cyclometalated complexes may include ligands other than the ligands required to form the cyclometalated complexes. Note that the cyclometalated complexes are preferable in terms of improving light-emitting efficiency because compounds that emit light from triplet exciton are included therein.
Moreover, specific examples of light-emitting polymer compounds include: poly-p-phenylenevinylene (PPV) derivatives such as MEH-PPV; polymer compounds of a n-conjugated system such as polyfluorene derivatives and polythiophene derivatives; polymers introducing low-molecular pigments and tetraphenyldiamine or triphenylamine to a main chain or a side chain and the like. The light-emitting polymer compounds and light-emitting low-molecular compounds can be used in combination.
The light-emitting layer 15 includes the light-emitting material and a host material, and the light-emitting material is dispersed in the host material in some cases. It is preferable that the host material has charge transporting properties, and it is also preferable that the host material is a hole-transporting compound or an electron-transporting compound.

A voltage is applied between the third conductive layer 16 and the first conductive layer 12 and the electrons are injected from the third conductive layer 16 to the light-emitting layer 15. In other words, in the exemplary embodiment, the third conductive layer 16 is a cathode layer.
A material used for the third conductive layer 16 is, similar to that of the first conductive layer 12, not particularly limited as long as the material has electric conductivity; however, it is preferable that the material has a low work function and is chemically stable. The specific examples of the material include Al, MgAg alloy and alloys of Al and alkali metals such as AlLi and AlCa.
However, as the material for the third conductive layer 16, in the case where the light is to be taken out from the third conductive layer 16 side of the electroluminescent element 10 (in the case where the surface of the third conductive layer 16 side is the surface from which the light is to be taken out, namely, the light-emitting surface), it is preferable to use a material transparent to the emitted light, as in the case of the first conductive layer 12.
The thickness of the third conductive layer 16 is preferably in the range of 0.01 µm to 1 µm, and more preferably 0.05 µm to 0.5 µm.

Moreover, to lower the barrier for the electron injection from the third conductive layer 16 into the light-emitting layer 15 and thereby to increase the electron injection efficiency, a cathode buffer layer that is not shown in the figure may be provided adjacent to the third conductive layer 16. The cathode buffer layer is required to have a lower work function than the third conductive layer 16, and metallic materials may be suitably used therefor. For example, the material thereof includes alkali metals (Na, K, Rb and Cs), alkaline earth metals (Sr, Ba, Ca and Mg), rare earth metals (Pr, Sm, Eu and Yb), one selected from fluoride, chloride and oxide of these metals and mixture of two or more selected therefrom. The thickness of the cathode buffer layer is preferably in the range of 0.05 nm to 50 nm, more preferably 0.1 nm to 20 nm, and still more preferably 0.5 nm to 10 nm.
Between the second conductive layer 14 and the third conductive layer 16, a layer other than the light-emitting layer 15 may be formed. As such a layer, a hole transporting layer, a hole blocking layer, an electron transporting layer or the like can be provided, and in response to the function of each layer, the charge transporting material exemplified as the above-described host material or other known materials can be used.

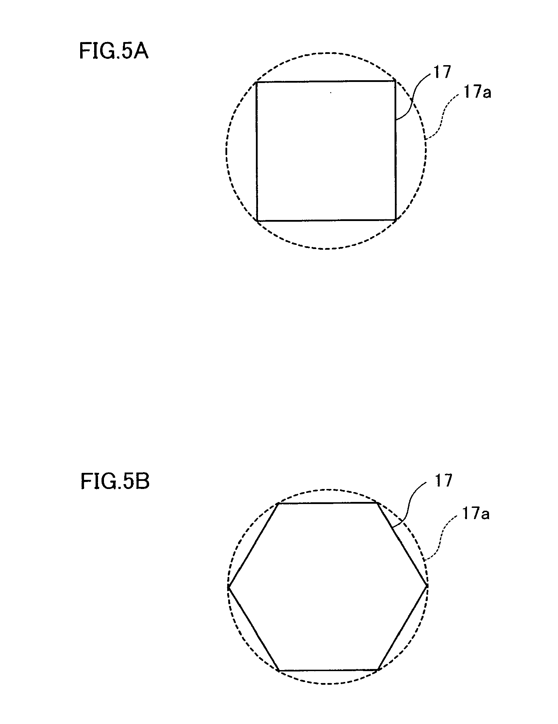

The shape of each contact hole 17 can be, for example, a cylindrical shape, a quadrangular prism shape or the like; however, the shape is not limited thereto.
For increasing the area of the light-emitting layer 15 to be formed on the dielectric layer 13 and brightness of the electroluminescent element 10, the size of the contact hole 17 is preferably as small as possible, as long as electrical connection between the first conductive layer 12 and the second conductive layer 14 is fully available. In the exemplary embodiment, the size of the contact hole 17 in the case of being viewed in a vertical direction with respect to the substrate 11 from the light-emitting surface side is, as shown in FIGS. 5A and 5B, represented by a diameter of a minimum circle 17a enclosing the shape of the contact hole 17 (the minimum enclosing circle). In other words, in FIG. 5A, the minimum enclosing circle in the case where the contact hole 17 is a square is indicated as 17a, and in FIG. 5B, the minimum enclosing circle in the case where the contact hole 17 is a regular hexagon is indicated as 17a. The diameter of the minimum enclosing circle 17a is preferably 0.01 µm to 2 µm. For example, in the case where the contact hole 17 has a cylindrical shape, the diameter of the cylinder is preferably 0.01 µm to 2 µm.
In addition, the ratio of the area of the contact holes 17 as viewed from the light-emitting surface to the area of the light-emitting region is preferably 0.1 or less, and especially preferably 0.001 to 0.1. This enables to obtain light emission with high brightness.
Further, the number of the contact holes 17 to be formed in one light-emitting region is 10² or more, and preferably 10⁴ or more. Still further, it is preferable that the contact holes 17 of great numbers are uniformly distributed in the light-emitting region. However, it is preferable that an upper limit of the number of contact holes 17 is such that, as described above, the ratio of the area of the contact holes 17 to the area of the light-emitting region is preferably 0.1 or less. These increase the uniformity in light emission in the light-emitting region. Note that, since FIG. 1 is a schematic view, it is not necessarily assumed to represent the ratio of each value.
Further, the contact holes 17 are formed only in the dielectric layer 13; however, the contact holes 17 may be further formed to extend and penetrate through the first conductive layer 12 and/or the third conductive layer 16.

Note that, in the above-described specific example, description was given of the case where the first conductive layer 12 was assumed to be the anode layer and the third conductive layer 16 was assumed to be the cathode layer; however, the specific example is not limited thereto, and the first conductive layer 12 may be the cathode layer and the third conductive layer 16 may be the anode layer.

### (Manufacturing Method of Electroluminescent Element)

Next, description will be given of a manufacturing method of the electroluminescent element in the present invention, while the electroluminescent element 10 described with FIG. 1 is taken as a specific example.

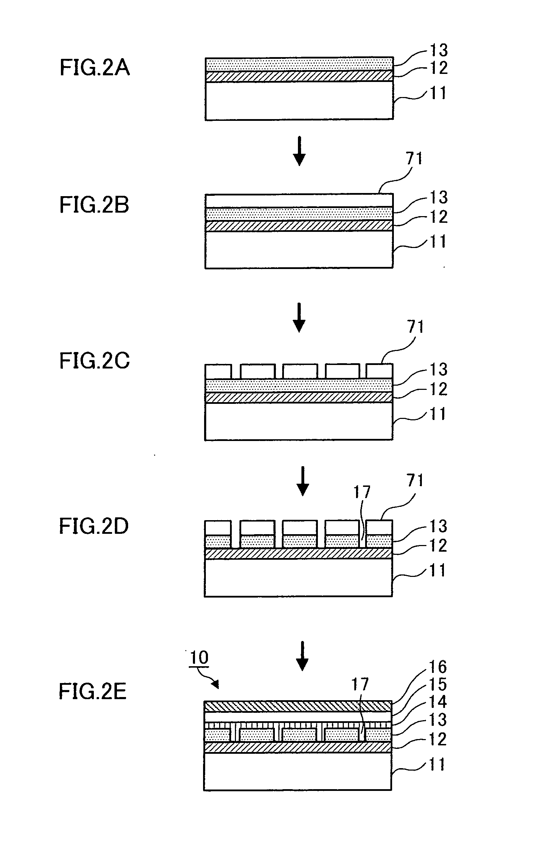

FIGS. 2A to 2E are diagrams for illustrating the manufacturing method of the electroluminescent element 10 to which the exemplary embodiment is applied.
First, on the substrate 11, the first conductive layer 12 and the dielectric layer 13 are formed by successive lamination (FIG. 2A). For forming these layers, a resistance heating deposition method, an electron beam deposition method, a sputtering method, an ion plating method, a CVD method or the like can be used. Alternatively, if a coating film-forming method (that is, a method for applying a target material solved in a solvent to the substrate and then drying the same) is applicable, the layers can be formed by a spin coating method, a dip coating method, an ink-jet printing method, a printing method, a spray-coating method and a dispenser-printing method or the like.

Next, the contact holes 17 are formed in the dielectric layer 13. For forming the contact holes 17, a method using lithography may be used, for example. To form the contact holes 17, first, a resist solution is applied on the dielectric layer 13 and then an excess resist solution is removed by spin coating or the like to form a resist layer 71 (FIG. 2B).
Thereafter, the resist layer 71 is covered with a mask, in which a predetermined pattern for forming the contact holes 17 is rendered, and is exposed with ultraviolet light (UV), an electron beam (EB) or the like. Here, by performing same magnification exposure (for example, in a case of contact exposure or proximity exposure), a pattern of the contact holes 17 with the same magnification as the mask pattern can be formed, whereas, by performing reduced exposure (for example, in a case of exposure using a stepper), a pattern of the contact holes 17 which is reduced with respect to the mask pattern can be formed. Next, exposed portions of the resist layer 71 are removed by use of a developing solution, and thereby pattern portions of the resist layer 71 are removed (FIG. 2C).
Next, the exposed portions of the dielectric layer 13 (in some cases, portions of the first conductive layer 12 in addition thereto) are removed by etching to form the contact holes 17 (FIG. 2D). Either dry etching or wet etching may be used as the etching. Reactive ion etching (RIE) or inductive coupling plasma etching is used as the dry etching, and a method of immersion in diluted hydrochloric acid or diluted sulfuric acid is used as the wet etching. Note that, by controlling etching conditions (a process time, gases to be used, pressure, and a substrate temperature) in performing the etching, the layers to be penetrated by the contact holes 17 can be selected.

Moreover, the contact holes 17 can be formed by a method of nanoimprinting.
Specifically, after forming the resist layer 71, a mask in which predetermined convex patterns to form a pattern are rendered is pressed against the surface of the resist layer 71 with pressure. By applying heat and/or light to the resist layer 71 in this state, the resist layer 71 is cured. Next, the mask is removed, and thereby the pattern, which is a pattern of the contact holes 17 corresponding to the convex patterns, is formed on a surface of the resist layer 71. The contact holes 17 can be formed by subsequently performing the aforementioned etching.

Then, the second conductive layer 14, the light-emitting layer 15 and the third conductive layer 16 are formed by successive lamination (FIG. 2E). For forming these layers, the method same as that in forming the first conductive layer 12 and the dielectric layer 13 can be used. Note that, in forming the second conductive layer 14, it is preferable to employ the coating film-forming method for filling the inside of the contact holes 17 with the material to form the second conductive layer 14.

With the above steps, the electroluminescent element 10 can be manufactured. Further, after the sequence of these processes, a protective layer or a protective cover (not shown) for stably using the electroluminescent element 10 for long periods and protecting the electroluminescent element 10 from outside may be mounted. As the protective layer, polymer compounds, metal oxides, metal fluorides, metal borides, or silicon compounds such as silicon nitrides and silicon oxides may be used. A lamination thereof may also be used. As the protective cover, glass plates, plastic plates with a surface treated with low hydraulic permeability, or metals may be used. The protective cover may be bonded to an element substrate by using a thermosetting resin or a photo-curable resin to be sealed. At this time, spacers may be used so that predetermined spaces are maintained, thus the prevention of scratches on the electroluminescent element 10 is facilitated. Filling the spaces with inert gases such as nitrogen, argon and helium prevents the oxidation of the third conductive layer 16 on the upper side. Especially, in a case of using helium, high thermal conductivity thereof enables heat generated from the electroluminescent element 10 upon application of voltage to be effectively transmitted to the protective cover. In addition, by putting desiccants such as barium oxide in the spaces, the electroluminescent element 10 is easily prevented from being damaged by moisture absorbed in the sequence of the aforementioned manufacturing processes.

### (Display Device)

Next, description will be given of a display device having the aforementioned electroluminescent element.

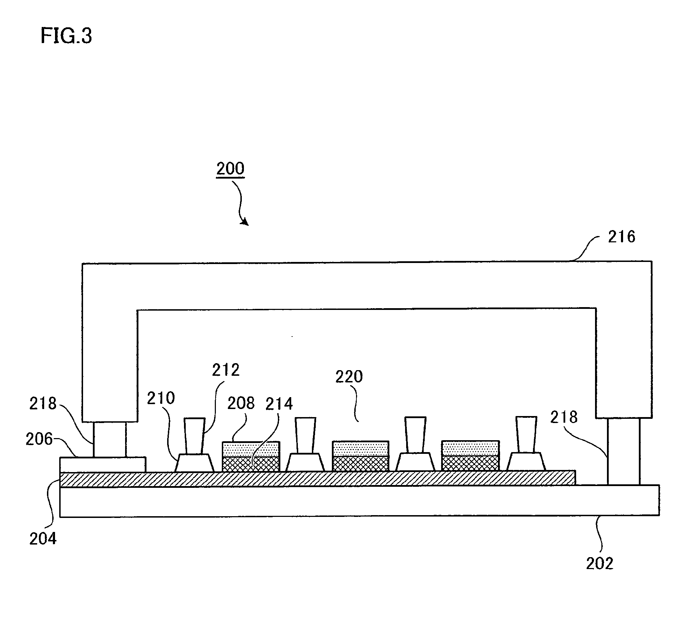

FIG. 3 is a diagram for illustrating a specific example of a display device using the electroluminescent element according to the exemplary embodiment.
A display device 200 shown in FIG. 3 is a so-called passive matrix display device, and is provided with a display device substrate 202, an anode wiring 204, an auxiliary anode wiring 206, a cathode wiring 208, an insulating film 210, a cathode partition 212, an electroluminescent element 214, a sealing plate 216, and a sealant 218.

The display device substrate 202 may employ a transparent substrate such as a rectangular glass substrate. The thickness of the display device substrate 202 is not particularly limited; however, the thickness may be, for example, 0.1 mm to 1 mm.

On the display device substrate 202, plural anode wirings 204 are formed. The anode wirings 204 are arranged in parallel with certain intervals. The anode wiring 204 is configured with a transparent conductive film, and can be made of, for example, ITO (indium tin oxide). The thickness of the anode wiring 204 may be set to, for example, 100 nm to 150 nm. The auxiliary anode wiring 206 is formed on an end portion of each of the anode wirings 204. The auxiliary anode wiring 206 is electrically connected to the anode wiring 204. With such a configuration, the auxiliary anode wiring 206 functions as a terminal for connection to an external wiring on the end portion side of the display device substrate 202, and accordingly, a current is supplied from a not-shown drive circuit provided outside to the anode wirings 204 through the auxiliary anode wirings 206. The auxiliary anode wiring 206 may be configured with, for example, a metal film having a thickness of 500 nm to 600 nm.

Plural cathode wirings 208 are also provided on the electroluminescent element 214. The plural cathode wirings 208 are arranged in parallel with each other, and each intersecting the anode wirings 204. Aluminum or aluminum alloy may be used for the cathode wiring 208. The thickness of the cathode wiring 208 is, for example, 100 nm to 150 nm. Further, similar to the auxiliary anode wiring 206 for the anode wirings 204, a not-shown auxiliary cathode wiring is provided on an end portion of each of the cathode wirings 208, and is electrically connected to the cathode wiring 208. Consequently, a current is capable of flowing between the cathode wirings 208 and the auxiliary cathode wirings.

On the display device substrate 202, the insulating film 210 is formed to cover the anode wirings 204. Opening portions 220 each having a rectangular shape are provided in the insulating film 210 to expose part of the anode wiring 204. The plural opening portions 220 are arranged in a matrix on the anode wirings 204. The electroluminescent elements 214 are provided at the opening portions 220 between the anode wirings 204 and the cathode wirings 208 as will be described later. In other words, each opening portion 220 becomes a pixel. Accordingly, a display region is formed corresponding to the opening portions 220. Here, the thickness of the insulating film 210 can be set to, for example, 200 nm to 300 nm, and the size of the opening portion 220 can be set to, for example, 300 µm square.

The electroluminescent elements 214 are formed at locations corresponding to the positions of the opening portions 220 on the anode wirings 204. Here, in the electroluminescent element 214, the first conductive layer 12, the dielectric layer 13, the second conductive layer 14, the light-emitting layer 15 and the third conductive layer 16 (refer to FIG. 1) are formed directly on the anode wirings 204 since the anode wirings 204 substitute as the substrate 11. The electroluminescent element 214 is held between the anode wirings 204 and the cathode wirings 208 at the opening portion 220. In other words, the first conductive layer 12 and the third conductive layer 16 of the electroluminescent element 214 are in contact with the anode wirings 204 and the cathode wirings 208, respectively. The thickness of the electroluminescent element 214 can be set to, for example, 150 nm to 200 nm.

On the insulating film 210, plural cathode partitions 212 are formed along the direction perpendicular to the anode wirings 204. The cathode partitions 212 play a role in spatially separating the plural cathode wirings 208 so that the cathode wirings 208 are not electrically connected to each other. Accordingly, each of the cathode wirings 208 is arranged between the adjacent cathode partitions 212. The size of the cathode partition 212 may be, for example, 2 µm to 3 µm in height and 10 µm in width.

The display device substrate 202 is bonded to the sealing plate 216 with the sealant 218. By this configuration, a space where the electroluminescent elements 214 are provided can be sealed, and thus the electroluminescent elements 214 can be prevented from deteriorating due to moisture in the air. As the sealing plate 216, for example, a glass substrate having a thickness of 0.7 mm to 1.1 mm can be used.

In the display device 200 with such a configuration, a current is supplied to the electroluminescent elements 214 via the auxiliary anode wirings 206 and the not-shown auxiliary cathode wirings from a not-shown driving device to cause the light-emitting layer 15 to emit light. By controlling light emission and non-light emission of the electroluminescent elements 214 corresponding to the aforementioned pixels with a controller, images can be displayed on the display device 200.

### (Lighting device)

Next, description will be given of a lighting device using the electroluminescent elements 10.

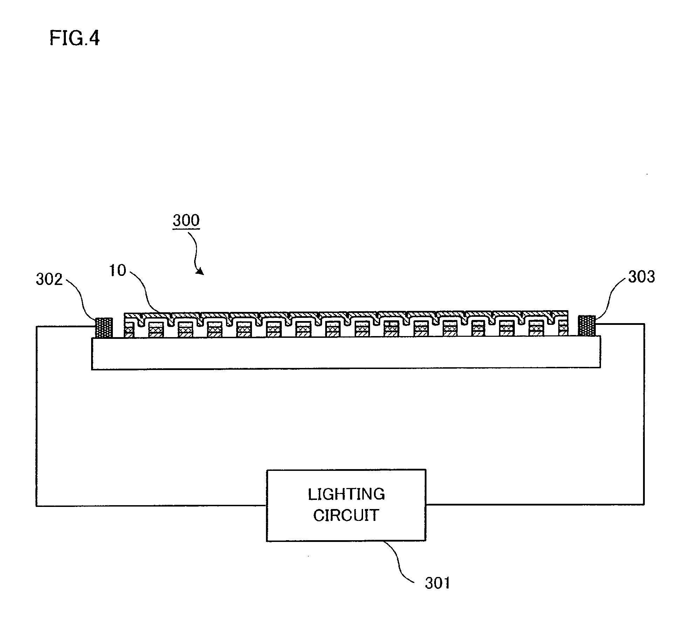

FIG. 4 is a diagram for illustrating a specific example of a lighting device having the electroluminescent element in the exemplary embodiment.
A lighting device 300 shown in FIG. 4 is configured with: the aforementioned electroluminescent element 10; a terminal 302 that is provided adjacent to the substrate 11 (refer to FIG. 1) of the electroluminescent element 10 and is connected to the first conductive layer 12 (refer to FIG. 1); a terminal 303 that is provided adjacent to the substrate 11 (refer to FIG. 1) and is connected to the third conductive layer 16 (refer to FIG. 1) of the electroluminescent element 10; and a lighting circuit 301 that is connected to the terminals 302 and 303 to drive the electroluminescent element 10.

The lighting circuit 301 has a not-shown DC power supply and a not-shown control circuit inside thereof, and supplies a current between the first conductive layer 12 and the third conductive layer 16 of the electroluminescent element 10 via the terminals 302 and 303. The lighting circuit 301 drives the electroluminescent element 10 to cause the light-emitting layer 15 (refer to FIG. 1) to emit light, the light is outputted through the substrate 11, and the light is utilized for illumination. The light-emitting layer 15 may be configured with the light-emitting material that emits white light, or, it may be possible to provide plural electroluminescent elements 10 using a light-emitting material that outputs each of the green light (G), blue light (B) and red light (R), thus making a synthetic light white.

### Examples

### (Example 1)

An electroluminescent element was produced by the method described below.
First, as the substrate 11, on a glass substrate made of fused quartz (25 mm per side, a thickness of 1mm), an ITO (indium tin oxide) film of 150 nm in thickness as the first conductive layer 12 and a silicon dioxide (SiO₂) layer of 50 nm in thickness as the dielectric layer 13 were formed by successive lamination with a sputtering device (E-401s manufactured by Canon ANELVA Corporation).

Next, a photoresist (AZ1500 manufactured by AZ Electronic Materials) of about 1 µm in thickness is formed by a spin coating method. Then, on a quartz (having a thickness of 3 mm) as a substrate, a mask A corresponding to a pattern in which circles are arranged in a triangular lattice was produced, and exposure was performed on a scale of 1/5 by use of a stepper exposure device (NSR-1505i6 manufactured by Nikon Corporation). Next, development was executed with 1.2% aqueous solution of TMAH (tetramethyl ammonium hydroxide: (CH₃)₄NOH) for patterning the resist layer. Thereafter, heat at a temperature of 130°C was applied for 10 minutes (post-baking process).

Next, by use of a reactive ion etching device (RIE-200iP manufactured by SAMCO Inc.), dry etching process was performed by causing a reaction for 18 minutes with CHF₃ as a reactant gas under conditions of a pressure of 0.3Pa and output bias/ICP = 50/100 (W). Then the contact holes 17 penetrating through the SiO₂ layer were formed by removing the residue of the resist by the resist removing solution. The contact holes 17 had a cylindrical shape with a diameter of 1 µm, and were arranged in a triangular lattice with a 4-µm pitch on an entire surface of the SiO₂ layer.

Next, the second conductive layer 14 was formed by applying an aqueous suspension (1.5% by mass in content) of a mixture of poly(3,4)-ethylendioxythiophene (PEDOT) and polystyrene sulfonate (PSS) (PEDOT:PSS = 1:6 in mass ratio) by the spin coating method (spin rate: 3000 rpm), and being left under a nitrogen atmosphere at the temperature of 140°C for an hour to be dried.
Next, the hole transport layer was formed by applying a xylene solution of a compound (A) indicated below onto the above-described second conductive layer 14 by the spin coating method (spin rate: 3000 rpm), and leaving under a nitrogen atmosphere at the temperature of 210°C for an hour to be dried.

Next, the light-emitting layer 15 was formed by applying a xylene solution including a compound (B), a compound (C) and a compound (D) indicated below with mass ratio of 9:1:90 onto the above-described hole transport layer by the spin coating method (spin rate: 3000 rpm), and leaving under a nitrogen atmosphere at the temperature of 140°C for an hour to be dried.

Next, on the above-described light-emitting layer 15, a layer of sodium fluoride (4 nm) as the cathode buffer layer and a layer of aluminum (130 nm) as the third conductive layer 16 were formed in order by a deposition method to prepare the electroluminescent element.
The prepared electroluminescent element has a light-emitting surface on the substrate surface side and includes one continuous light-emitting region. Moreover, as the electroluminescent element was observed from the light-emitting surface side, the number of the contact holes in the above-described light-emitting region was about 2 x 10⁷. The ratio of the area of the contact holes to the area of the light-emitting region was 0.057.

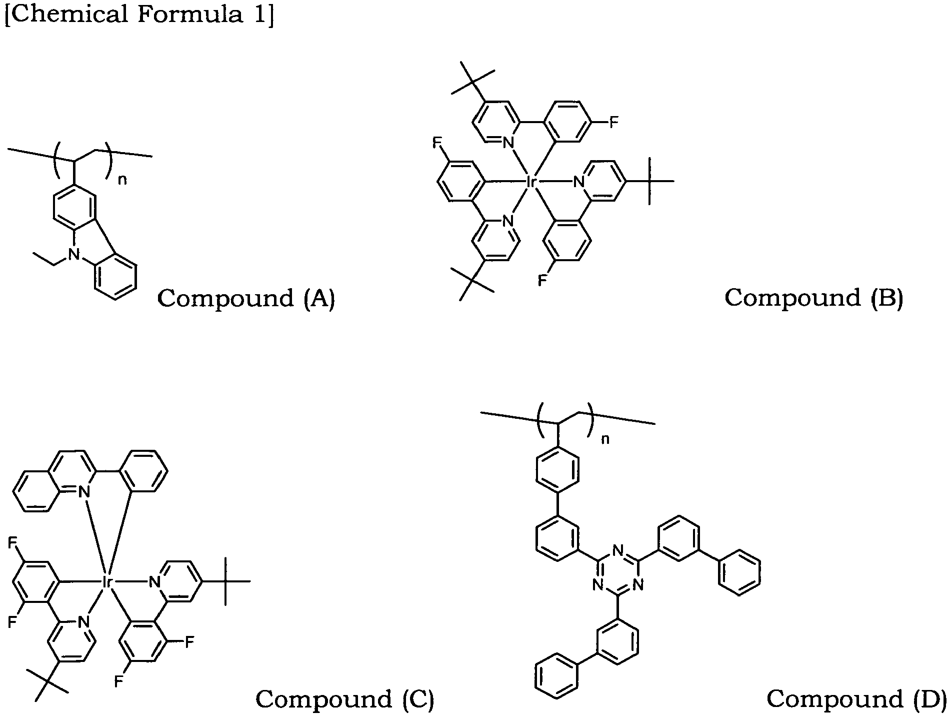

### [Example 2]

An electroluminescent element was prepared in the same manner as Example 1 except that the composition of the light-emitting layer was set such that the mass ratio of compounds indicated below was a compound (E):a compound (F):a compound (G):the compound (D) = 10:0.4:0.6:89 (mass ratio).
The prepared electroluminescent element has a light-emitting surface on the substrate surface side and includes one continuous light-emitting region. Moreover, as the electroluminescent element was observed from the light-emitting surface side, the number of the contact holes in the above-described light-emitting region was about 2 x 10⁷. The ratio of the area of the contact holes to the area of the light-emitting region was 0.057.

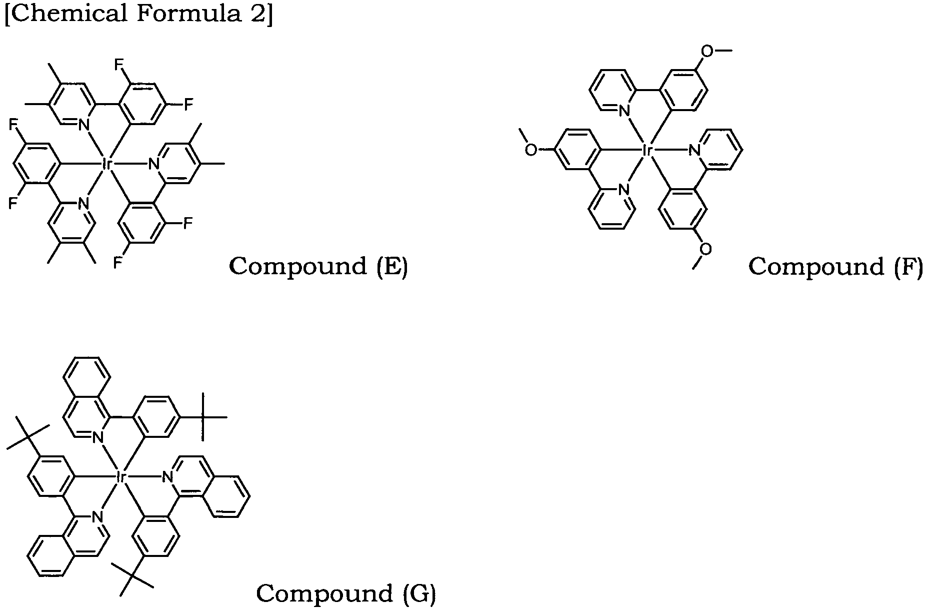

### (Example 3)

First, similar to Example 1, on a glass substrate of fused quartz, an ITO film of 150 nm in thickness as the first conductive layer 12 and an SiO₂ layer of 50 nm in thickness as the dielectric layer 13 were formed by successive lamination.
Next, similar to Example 1, a photoresist layer of 1 µm in thickness was formed on the SiO₂ layer, and thereafter, with a fused quartz as a base material, exposure of the photoresist layer was performed on a scale of 1/5 by a stepper exposure device by use of a mask B corresponding to a pattern in which circles are arranged in a triangular lattice. Next, the photoresist layer was patterned by development with 1.2% aqueous solution of TMAH and then heating at 130°C for 10 minutes.

Next, by use of a reactive ion etching device (RIE-200iP manufactured by SAMCO Inc.), dry etching process was performed by causing a reaction for 18 minutes with CHF₃ as a reactant gas under conditions of a pressure of 0.3Pa and output bias/ICP = 50/100 (W). Thereafter, the reactant gas was changed to a mixed gas of Cl₂ and SiCl₄, and dry etching process was performed by causing a reaction for 5 minutes under conditions of a pressure of 1Pa and output bias/ICP = 20/100 (W). Then the contact holes 17 penetrating through the SiO₂ layer and the ITO film were formed by removing the residue of the resist by the resist removing solution. The contact holes 17 had a cylindrical shape with a diameter of 0.5 µm, and were arranged in a triangular lattice with a 1.6-µm pitch on an entire surface of the SiO₂ layer and the ITO film.

Next, by use of a sputtering device, an ITO film of 20 nm in thickness as the second conductive layer 14 was formed on an entire surface of the SiO₂ layer and inside the contact holes 17.
Then, similar to Example 1, an electroluminescent element was prepared by forming the hole transport layer, the light-emitting layer 15, the cathode buffer layer and the third conductive layer 16 on the second conductive layer 14 by successive lamination.

The prepared electroluminescent element has a light-emitting surface on the substrate surface side and includes one continuous light-emitting region. Moreover, as the electroluminescent element was observed from the light-emitting surface side, the number of the contact holes 17 in the above-described light-emitting region was about 1.4 x 10⁸. The ratio of the area of the contact holes 17 to the area of the light-emitting region was 0.089. Note that the refractive index of the SiO₂ layer was 1.4.

### (Comparative Example 1)

An electroluminescent element was prepared in the same manner as Example 1 except that a mask C was used as a pattern mask for exposing the photoresist layer.
The prepared electroluminescent element had a light-emitting surface on the substrate surface side, included one continuous light-emitting region, and contact holes having a cylindrical shape with a diameter of 2.5 µm arranged in a triangular lattice with a 5-µm pitch on an entire surface of the SiO₂ layer. As the electroluminescent element was observed from the light-emitting surface side, the number of the contact holes in the above-described light-emitting region was about 1.4 x 10⁷. The ratio of the area of the contact holes to the area of the light-emitting region was 0.23. Note that the refractive index of the SiO₂ layer was 1.4.

When a voltage was applied to the electroluminescent elements prepared in Examples 1 to 3 and Comparative Example 1 by a DC power supply (SM2400 manufactured by Keithley Instruments Inc.), in each Example, white light with uniform brightness in the light-emitting surface was observed by visual inspection; however, in Comparative Example 1, non-uniform portion was observed.
Further, in Table 1 below, light-emitting efficiency and a driving voltage in lighting the electroluminescent elements prepared in Examples 1 to 3 and Comparative Example 1 at an average brightness of 300 cd/m² were indicated. The electroluminescent elements in Examples 1 to 3 show light emission sufficiency higher than that of the electroluminescent element in Comparative Example 1, and also have excellent property of being able to be driven by a low voltage.

**[Table 1]**

| | Light-Emitting Efficiency (cd/A) | Driving Voltage (V) |
|---|---|---|
| Example 1 | 33 | 6.0 |
| Example 2 | 31 | 5.9 |
| Example 3 | 36 | 5.9 |
| Comparative Example 1 | 28 | 6.6 |

### Reference Signs List

10: Electroluminescent element
11: Substrate
12: First conductive layer
13: Dielectric layer
14: Second conductive layer
15: Light-emitting layer
17: Contact hole
17a: Minimum enclosing circle
200: Display device
300: Lighting device

## Claims

1. An electroluminescent element comprising:
a lamination section in which a first conductive layer, a dielectric layer, a second conductive layer, a light-emitting layer and a third conductive layer are laminated in order; and
contact holes that penetrate through at least the dielectric layer to electrically connect the first conductive layer and the second conductive layer, wherein, as viewed from a light-emitting surface side,
(i) at least one continuous light-emitting region is provided, and
(ii) a number of the contact holes is not less than 10² per the one light-emitting region and a ratio of an area of the contact holes to an area of the light-emitting region is not more than 0.1.

2. The electroluminescent element according to claim 1, wherein the ratio of the area of the contact holes to the area of the light-emitting region is 0.001 to 0.1.

3. The electroluminescent element according to any one of claims 1 and 2, wherein a diameter of a minimum circle enclosing a shape of each contact hole as viewed from the light-emitting surface side is 0.01 µm to 2 µm.

4. The electroluminescent element according to any one of claims 1 to 3, wherein the contact holes are formed to further penetrate through the first conductive layer.

5. The electroluminescent element according to any one of claims 1 to 4, wherein the first conductive layer, the dielectric layer and the second conductive layer are transparent to a wavelength of light to be emitted.

6. The electroluminescent element according to any one of claims 1 to 5, wherein a refractive index of the dielectric layer is 1.0 to 1.5.

7. The electroluminescent element according to any one of claims 1 to 6, wherein the second conductive layer includes one of conductive metal oxide and conductive polymer.

8. The electroluminescent element according to any one of claims 1 to 7, wherein at least one layer, which is selected from a hole transporting layer, a hole blocking layer and an electron transporting layer, is further provided between the second conductive layer and the third conductive layer.

9. A display device comprising the electroluminescent element according to any one of claims 1 to 8.

10. A lighting device comprising the electroluminescent element according to any one of claims 1 to 8.
